# EUROPÄISCHE PATENTSCHRIFT

(11) **EP 0 442 357 B1**
(45) Veröffentlichungstag und Bekanntmachung des Hinweises auf die Patenterteilung: **20.12.1995**
(21) Anmeldenummer: 91101561.8
(22) Anmeldetag: 06.02.1991
(51) Int. Cl.: B29C 31/04, B29C 43/24, B29C 35/08

(54) **Verfahren zur Herstellung von Photopolymerplatten**
Process for the preparation of photopolymer plates
Procédé pour la fabrication de plaques en photopolymère

(30) Priorität: 14.02.1990 DE 4004512
(43) Veröffentlichungstag der Anmeldung: 21.08.1991
(73) Patentinhaber: E.I. DU PONT DE NEMOURS & COMPANY INCORPORATED, Wilmington Delaware 19898 (US)
(72) Erfinder: Bohm, Dieter, Dr. Dipl.-Chem., W-6228 Eltville (DE); Faust, Raimund-Josef, Dr. Dipl.-Chem., W-6200 Wiesbaden (DE); Gersdorf, Joachim, Dr. Dipl.-Chem., W-6200 Wiesbaden (DE); Petry, Rudolf, Dipl.-Ing., W-6200 Wiesbaden (DE); Schlosser, Hans Joachim, Dr. Dipl.-Chem., W-6200 Wiesbaden (DE)
(74) Vertreter: Pistor, Wolfgang, Dipl.-Chem.

(56) Entgegenhaltungen:
- EP-A- 0 080 665
- DE-A- 3 428 817
- DE-A- 3 730 043
- FR-A- 2 316 064
- KUNSTSTOFFE Bd. 80, Nr. 1, Januar 1990, MüNCHEN Seiten 21 - 25; W. MÜLLER, M.
- DIENST: 'in-line-herstellung von platten und folien'
- KAUTSCHUK + GUMMI KUNSTSTOFFE Bd. 37, Nr. 3, März 1984, HEIDELBERG Seiten 212 - 220; G. CAPELLE: 'roller-head-anlagen für innerlining'

## Beschreibung

Die vorliegende Erfindung betrifft ein Verfahren zur Herstellung von Photopolymerplatten mit hoher Dickenkonstanz und großer Homogenität, bei dem eine Mischung aus einem thermoplastisch verarbeitbaren Polymeren, einer oder mehreren ethylenisch ungesättigten Verbindung(en), einem Photoinitiator sowie gegebenenfalls weiteren festen und/oder flüssigen Zusatzstoffen extrudiert und anschließend kalandriert wird.

Photopolymerplatten werden beispielsweise zur Herstellung von Reliefdruckplatten für den Hochdruck, insbesondere für den Flexodruck, eingesetzt. Die für diesen Zweck verwendeten Platten mit Dicken zwischen 0,5 und 7 mm müssen eine große Dickengenauigkeit und Dickenkonstanz aufweisen, so daß beim kontinuierlichen Herstellungsprozeß die Dickenabweichungen des thermoplastischen Materials über die Breite und in Prozeßrichtung minimiert sind. Neben der Konstanz in der Dicke des Produkts ist auch eine reproduzierbar einstellbare Homogenität der Zusammensetzung des thermoplastischen Materials wesentlich.

Es ist bereits aus den DE-A 21 38 582 (= GB-A 1 358 062) und 22 15 090 (= US-A 4 423 135) bekannt, lichtempfindliche Schichten, bestehend aus einem thermoplastischen Polymeren, einer ethylenisch ungesättigten Verbindung, einem Photoinitiator und weiteren Zusatzstoffen, herzustellen, indem man die Komponenten in einer Mischvorrichtung, z. B. einem Innenmischer, einem Walzenmischer oder einer Mühle unter Aufschmelzen des Polymeren homogenisiert und diese Mischung in einem separaten Arbeitsgang durch Extrusion, Kalandrieren oder Plattenpressen zu Photopolymerschichten formt. Nachteilig bei diesem Verfahren ist die diskontinuierliche Arbeitsweise. Die mindestens zweimalige thermoplastische Belastung des Materials kann zu einer Veränderung der Mischungsbestandteile führen; störende Gelbildung und Inhomogenität können die Folge sein.

In der EP-A 0 080 665, von welcher der Oberbegriffs des Anspruchs 1 ausgeht, wird ein Verfahren beschrieben, bei dem in einem selbstreinigenden Zweischneckenextruder die Mischungsbestandteile aufgeschmolzen und homogenisiert werden und die Schmelze durch eine Breitschlitzdüse in den Spalt eines Zweiwalzenkalanders unter Ausbildung eines rotierenden Wulstes ausgetragen und zu Photopolymerplatten ausgeformt wird. Für die angestrebte dickengenaue und dickenkonstante Einstellung der Schicht soll es dabei entscheidend sein, daß sich vor dem Walzenspalt ein rotierender Wulst aus dem zu verarbeitenden Material bildet. Nachteilig bei diesem Verfahren ist, daß die Spaltöffnung der Breitschlitzdüse auf die jeweilig gewünschte Dicke der den Kalanderwalzenspalt verlassenden Photopolymerschicht abgestimmt werden muß. Nachteilig ist weiterhin die direkte Einspeisung der Schmelze aus dem Zweischneckenextruder in die Breitschlitzdüse. Bekanntermaßen zeichnet sich ein Zweischneckenextruder durch eine diskontinuierliche Förderung aus, die zu Druckpulsationen führt (vgl. z. B. "Der Extruder als Plastifiziereinheit", S. 114/115, VDI-Verlag, Düsseldorf 1977). Die Folge ist ein ungleichmäßiger Schmelzeaustrag in den Kalanderwalzenspalt mit negativen Folgen für die Dickenkonstanz der Photopolymerplatten. Ein weiterer Nachteil ist das Arbeiten mit einem rollenden Wulst im Kalanderspalt, wodurch Luft in das thermoplastische Material eingezogen werden kann, die negative Auswirkungen auf die Transparenz und die Lagerfähigkeit des Produkts haben kann.

Aufgabe der vorliegenden Erfindung war es daher, ein kontinuierlich arbeitendes Verfahren zur Herstellung von Photopolymerplatten mit großer Homogenität in der Zusammensetzung und hoher Dickengenauigkeit und -konstanz zu entwickeln, das die Nachteile der oben angeführten bekannten Verfahren nicht zeigt und insbesondere eine hohe Variabilität in der Dicke der auszuformenden Platten ermöglicht.

Gelöst wird die Aufgabe durch ein kontinuierlich arbeitendes Verfahren zur Herstellung von Photopolymerplatten, bei dem ein photopolymerisierbares Gemisch, enthaltend wenigstens ein thermoplastisch verarbeitbares, elastomeres Polymeres, wenigstens eine einfach oder mehrfach ethylenisch ungesättigte Verbindung, die radikalisch polymerisierbar ist und einen Siedepunkt bei Normaldruck oberhalb von 100 °C hat, sowie wenigstens eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und anschließend über eine Breitschlitzdüse einem Zweiwalzenkalander zugeführt wird, dadurch gekennzeichnet, daß die Schmelze nach dem Schneckenextruder über eine Schmelzedosierpumpe in die Breitschlitzdüse weitertransportiert und dem Zweiwalzenkalander mit einer solchen Geschwindigkeit zugeführt wird, daß sich im Walzenspalt kein rotierender Wulst ausbildet.

Die auf diese Weise hergestellten Photopolymerplatten weisen eine
- hohe Dickengenauigkeit,
- hohe Dickenkonstanz,
- ausgezeichnete Planlage im Verbundsystem,
- gute Lagerfähigkeit,
- geringe Stippenneigung,
- hohe Transparenz und
- große Homogenität der Schichtbestandteile
auf. Das erfindungsgemäße Verfahren gewährleistet eine Verarbeitung des photopolymerisierbaren Gemisches von hoher produktschonender Qualität. Insbesondere wird dies durch einen extrem konstanten Materialfluß und einen nur sehr geringen Temperaturgradienten über die Breite des Materialflusses bewirkt.

Die im erfindungsgemäßen Verfahren verarbeitbaren photopolymerisierbaren Gemische enthalten folgende Bestandteile:
Als thermoplastisch verarbeitbare Polymere, die in dem erfindungsgemäßen Verfahren allein oder im Gemisch miteinander eingesetzt werden können, sind Polyethylen, Polypropylen, Polyvinylchlorid, Styrolpolymerisate, insbesondere Styrol-Diencopolymerisate, Butadien- und/oder Isopren-Polymerisate, Butadien/Acrylnitril-Copolymerisate (Nitril-Kautschuke), elastomere Polyurethane, Polyamide, Polyimide, Polyamidimide, (Meth)acrylatpolymerisate, Vinylchlorid/Vinylacetat-Copolymere, Vinylidenchloridpolymerisate, Vinylester-, insbesondere Vinylacetat- oder Vinylpropionat-Polymerisate, Polyvinylalkohole u.a., zu verwenden.

Je nach Art der eingesetzten thermoplastisch verarbeitbaren Polymeren sind die für diese Polymeren an sich bekannten, allgemeinen Verarbeitungsbedingungen, wie z. B. Temperaturbelastbarkeit, Plastifizierung, Hilfsmittelzusätze etc., zu berücksichtigen.

Bevorzugt werden als thermoplastisch verarbeitbare Polymeren neben den Polyurethanen und Vinylalkoholpolymeren die elastomeren, kautschukartigen Polymerisate einsetzt, wie insbesondere die Homopolymerisate des Butadiens und Isoprens, die Copolymerisate des Butadiens und Isoprens untereinander sowie mit anderen copolymerisierbaren Monomeren, z. B. Nitril-Kautschuke, wie Butadien/ Acrylnitril-Copolymerisate mit 15 bis 45 Gew.-% an einpolymerisiertem Acrylnitril, carboxylgruppentragende Nitril-Kautschuke, vinylchloridhaltige Nitril-Kautschuke und die Mehrblock-Copolymerisate aus Styrol, Butadien und/oder Isopren, wie AB-Zweiblockcopolymerisate, ABA-Dreiblockcopolymerisate, ABC-Dreiblockcopolymerisate, wie sie in den DE-A 21 38 582, 22 15 090 und 29 42 183 beschrieben sind, Sternblockcopolymerisate und teil- oder vollständig hydrierte Blockcopolymerisate der genannten Art.

Die durch Photopolymerisation vernetzbaren Gemische enthalten im allgemeinen 20 bis 98 Gew.-%, vorzugsweise 30 bis 95 Gew.-%, des elastomeren Polymeren. In einer besonderen Ausführungsform werden die Polymeren in Granulatform eingesetzt.

Als ethylenisch ungesättigte Verbindungen dienen niedermolekulare, im allgemeinen niedrigviskose, flüssige organische Verbindungen, die ein oder mehrere polymerisierbare ethylenisch ungesättigte Doppelbindungen aufweisen. Diese Verbindungen sollen der vorzugsweise radikalisch initiierten Polymerisation zugänglich sein, so daß sie unmittelbar zur Ausbildung von Vernetzungen zwischen den hochmolekularen Polymerketten beitragen. Vorzugsweise werden solche organischen Verbindungen eingesetzt, die zwei oder mehr polymerisierbare, ethylenisch ungesättigte Doppelbindungen aufweisen. Diese Verbindungen können dabei allein oder in Mischung miteinander eingesetzt werden. So sind beispielsweise in vielen Fällen Mischungen aus Verbindungen mit zwei oder mehreren ethylenisch ungesättigten Doppelbindungen von Vorteil. Gleicherweise können aber auch Mischungen von organischen Verbindungen mit mehreren, vorzugsweise zwei, ethylenisch ungesättigten Doppelbindungen mit solchen Verbindungen, die nur eine ethylenisch ungesättigte Doppelbindung im Molekül aufweisen, eingesetzt werden. Art und Menge der Verbindungen richten sich einerseits nach dem eingesetzten thermoplastisch verarbeitbaren Polymeren sowie andererseits nach der erwünschten Reaktivität der flächigen Gebilde, d.h. dem möglichen erzielbaren Vernetzungsgrad.

Im allgemeinen werden die Verbindungen in Mengen von 1 bis 70 Gew.-%, vorzugsweise von 2 bis SO Gew.-%, bezogen auf alle Mischungsbestandteile der Photopolymermischung, eingesetzt. In den Mischungen aus monoethylenisch ungesättigten und mehrfach ethylenisch ungesättigten organischen Verbindungen liegt der Anteil der monoethylenisch ungesättigten organischen Verbindungen üblicherweise im Bereich von 10 bis 50 Gew.-%, bezogen auf die Summe der eingesetzten niedermolekularen ethylenisch ungesättigten organischen Verbindungen.

Bevorzugt werden solche niedermolekularen ethylenisch ungesättigten Verbindungen eingesetzt, die mit dem thermoplastisch verarbeitbaren Polymeren verträglich sind, insbesondere, wenn an die Photopolymerschicht hohe Anforderungen hinsichtlich der optischen Eigenschaften, wie z. B. Klarheit und Transparenz, gestellt werden. Durch die Verarbeitung im Extruder bedingt, sollen die eingesetzten ethylenisch ungesättigten Verbindungen im allgemeinen einen Siedepunkt über 100 °C bei Atmosphärendruck besitzen.

Beispiele für derartige Verbindungen sind insbesondere die Acrylate und Methacrylate von mono- oder polyfunktionellen Alkoholen, wie z. B. die Di- und Poly-(meth)acrylate von Ethylenglykol, Di-, Tri-, Tetra- oder Polyethylenglykolen mit Molekulargewichten im Bereich von 200 bis 500, Propylenglykol, Butandiol, Hexandiol, Dodecandiol, Tetradecandiol, 1,1,1-Trimethylolpropan, 1,2,4Butantriol, Pentaerythrit u.a. Ebenso geeignet sind die entsprechenden Monoacrylate und/oder Monomethacrylate der genannten Diole und Polyole oder von Alkoholen mit 1 bis 8 C-Atomen, z. B. Methanol, Ethanol, Propanol, Butanol, 2-Ethyl-hexanol. Besonders bevorzugt sind hierunter Ethylenglykolmonomethacrylat, 1,3-Propandiolmonomethacrylat, Glycerinmono- und -diacrylat, Hexandioldiacrylat, Hexandioldimethacrylat, 2-Ethylhexylacrylat, Laurylmethacrylat, Stearylmethacrylat, 1,2,3-Butantriolmonomethacrylat, Pentaerythrittriacrylat, Polyethylenglycolmethyletheracrylat, Tetradecanethylenglycolmethacrylat, Tetradecan-1,14-diol-dimethacrylat oder der Trisether aus Glycerin und 3 mol N-Methylolacrylamid oder -methacrylamid. Ebenso sind Alkenylphosphon- oder -phosphinsäureester nach der DE-A 38 17 424 einsetzbar. Weiter geeignet sind auch Fumarsäureester, wie sie in der deutschen Patentanmeldung P 40 01 465.7 und der US-A 4 179 130 beschrieben sind.

Als Photoinitiatoren werden im photopolymerisierbaren Gemisch solche bekannten Verbindungen verwendet, die eine hinreichend thermische Stabilität bei der Verarbeitung der Aufzeichnungsmaterialien sowie eine ausreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z.B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der DE-A 37 28 168 beschriebenen 6-Acyl-6H-dibenzo[c,e][1,2]-oxaphosphorin6-oxide, insbesondere das 6-(2,4,6-Trimethylbenzoyl)-6H-dibenzo[c,e][1,2]oxaphosphorin-6-oxid. Die Photoinitiatoren lassen sich auch in Kombination miteinander oder mit Coinitiatoren bzw. Aktivatoren verwenden, z.B. mit Michlers Keton und seinen Derivaten oder 2-Alkyl-anthrachinonen. Die Menge an Photoinitiator beträgt im allgemeinen etwa 0,01 bis 10 Gew.-%, bevorzugt etwa 0,5 bis 5 Gew.-% des photopolymerisierbaren Gemisches.

Oft ist es von Vorteil, dem photopolymerisierbaren Gemisch noch weitere Hilfs- und Zusatzstoffe zuzugeben, z. B. Inhibitoren der thermischen Polymerisation wie Hydrochinon und seine Derivate, 2,6-Di-tert.-butyl-pkresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Lichthofschutzmittel, Antiozonantien, beispielsweise ein mikrokristallines Wachs oder ein Paraffinwachs, Vernetzungsmittel, Regler, Füllmittel, Fließmittel und Weichmacher.

Im erfindungsgemäßen Verfahren wird zum Aufschmelzen und Homogenisieren der Mischungsbestandteile ein Schneckenextruder, vorzugsweise ein selbstreinigender, gleichförmig rotierender Zweischneckenextruder mit mindestens einer Öffnung zur Dosierung der Mischungsbestandteile, mindestens einer Entgasungs- und einer Austragsöffnung eingesetzt. Sofern nur eine Öffnung zur Dosierung der Mischungsbestandteile vorgesehen ist, werden die Bestandteile der photopolymerisierbaren Mischung, das thermoplastische Polymere vorzugsweise in Granulatform, separat in einem grundsätzlich bekannten Mischer vorgemischt und kontinuierlich dem Schneckenextruder, vorzugsweise dem Zwei- oder Mehrschneckenextruder, zugeführt. Geeignete Mischer sind beispielsweise Pflugschar-, Bandschnecken-, Paddel-, Trommel- oder Freifallmischer. Insbesondere wird im Falle einer separaten Vormischung ein Verfahren bevorzugt, das in der gleichzeitig eingereichten deutschen Patentanmeldung P 40 04 510.2 beschrieben ist. Bei diesem Verfahren wird das Polymere in Granulatform mit den flüssigen Bestandteilen unter Zuhilfenahme eines in der flüssigen Mischung nicht-löslichen Pulvers einer mittleren Korngröße von 0,005 bis 50 »m gemischt, bevor die Mischung einem Zweischneckenextruder zugeführt wird.

In einer weiteren besonderen Ausführungsform ist es möglich, unter der Voraussetzung, daß der Extruder mehrere Eintragsöffnungen aufweist, in einen ersten Bereich des Extruders das thermoplastische Polymere, gegebenenfalls gemischt mit anderen festen Hilfs- und Zusatzstoffen, einzutragen und in einen zweiten Bereich die flüssigen Bestandteile des photopolymerisierbaren Gemisches - gegebenenfalls mit dem Rest der in den ersten Bereich noch nicht eingebrachten festen Bestandteile - zuzudosieren und zu homogenisieren.

Der erste Bereich des vorzugsweise verwendeten Zweischneckenextruders ist beheizbar, wird aber bevorzugt nicht beheizt, gegebenenfalls sogar gekühlt. Die folgenden Bereiche sind beheizt, gegebenenfalls auf unterschiedliche Temperaturen. Die maximal erreichte Temperatur soll gewährleisten, daß das Polymere aufschmilzt, ohne aber eine Überhitzung bzw. eine zu große thermische Belastung für die Mischung hervorzurufen.

Der für das erfindungsgemäße Verfahren bevorzugte Zweischneckenextruder weist insbesondere vier Bereiche auf, einschließlich eines Entgasungsbereich und eines darauf folgenden Bereichs zum Druckaufbau. Wenn ein separates Vormischen der Bestandteile des photopolymerisierbaren Gemisches vorgesehen ist, wird die in dieser Weise vorgemischte Mischung vorzugsweise dem ersten Bereich zugeführt.

Im beheizten Bereich des Extruders, in dem das Aufschmelzen und die Homogenisierung des Gemisches stattfinden, sind die Schnecken so ausgebildet und angeordnet, daß eine optimale Mischung und Homogenisierung gewährleistet werden. Beispielsweise können zusätzlich Zahn- und Knetblöcke vorhanden sein, wodurch auch eine vorteilhafte Quervermischung erfolgt. Eine gute Dispergierung wird aufgrund der Erzeugung von unterschiedlich starken Scherkraftfeldern bewirkt. Der beheizte Bereich weist im Mittel Temperaturen von 100 bis 220 °C, insbesondere 130 bis 170 °C, auf.

Auf den Aufschmelz- und Homogenisierungsbereich folgt ein Entgasungsbereich. Die Entgasung der Schmelze erfolgt im allgemeinen durch Anlegen eines geeigneten Vakuums an die Entgasungsöffnung. Im Anschluß an den Entgasungsbereich kann noch ein weiterer Bereich zum Druckaufbau folgen, wobei Schneckenelemente mit kleiner werdender Steigung - in Produktfließrichtung gesehen hintereinander angeordnet sind. Der Entgasungsbereich ist vorzugsweise auf 60 bis 140 °C beheizt.

Die Schneckenlänge des Extruders insgesamt beträgt das 5- bis 50fache, vorzugsweise das 10- bis 40fache, des Schneckendurchmessers.

Im erfindungsgemäßen Verfahren schließt sich an den Zweischneckenextruder eine Schneckendosierpumpe an. Vorzugsweise handelt es sich hierbei um eine Zahnradschmelzepumpe, wie sie in Ullmanns Encyklopädie der technischen Chemie, Band 3, 4. Auflage (1973), Verfahrenstechnik II und Reaktionsapparate, Seite 169, beschrieben ist. Insbesondere ist eine gerade-verzahnte Zahnradschmelzepumpe geeignet.

Der Schmelzedosierpumpe folgt - in Produktfließrichtung gesehen - eine Breitschlitzdüse. In dieser wird die Verteilung der Schmelze über geeignet gestaltete Fließkanäle auf die Düsenbreite vorgenommen. Die Düsenmitte und die Düsenlippen sind separat beheizbar. Vorteilhaft ist, wenn die Lippen über ihre gesamte Breite separat beheizbare Zonen aufweisen.

Die äußeren Abmessungen der Düse sind derart gestaltet, daß die die Düse verlassende Schmelze auf dem kürzesten Weg in den Spalt eines Zweiwalzenkalanders geführt wird. Im Walzenspalt wird die Photopolymermischung in der gewünschten Dicke ausgeformt.

In dem erfindungsgemäßen Verfahren ist es erfindungswesentlich, daß sich kein Rollwulst (rotierender Wulst) zwischen den Kalanderwalzen ausbildet. Dadurch wird gewährleistet, daß keine Luft in die noch thermoplastisch verformbare Mischung eingetragen wird. Ein Rollwulst kann zu Inhomogenitäten an der Oberfläche und in der Polymerplatte selbst führen und damit die optischen Eigenschaften in negativer Weise beeinflussen.

Um einen Rollwulst im Kalanderspalt zu vermeiden, ist eine präzise Dosierung der Schmelze aus der Breitschlitzdüse in den Kalanderspalt notwendig. Ein Überangebot an Schmelze vom Extruder bewirkt die Entstehung eines solchen Rollwulstes. Ein Mangel an Schmelze dagegen kann Pulsationen verursachen und außerdem zum Bahnabriß führen. Eine kleine Wulstausbildung am Kalanderspalt ist dagegen nicht zu vermeiden. Diese ist allerdings nicht mit dem Rollwulst des Standes der Technik zu verwechseln.

Ein wesentliches Merkmal des erfindungsgemäßen Verfahrens ist es daher, die Schmelze in einer solchen Menge in den Kalanderspalt einzuführen, daß sich kein Rollwulst bildet, aber zugleich die dabei notwendigerweise zu erwartenden Pulsationen, die die Dickenkonstanz und die Dickengenauigkeit beeinträchtigen, auszuschließen.

Eine Möglichkeit zur Kontrolle des Schmelzeangebots im Kalanderspalt bietet die Messung des Drucks mit Hilfe einer Druckmeßsonde in der Breitschlitzdüse und eine über das Ergebnis einer solchen Druckmessung erfolgende Regelung der Umlaufgeschwindigkeit der Kalanderwalzen, insbesondere durch Vorwärtsregelung. Ebenso kann in Kombination hierzu oder auch allein die Drehzahl der Schmelzedosierpumpe geregelt werden, um die Ausbildung eines Rollwulstes zu verhindern. Insbesondere wird in Kombination mit der Regelung der Umlaufgeschwindigkeit der Kalanderwalzen eine Rückwärtsregelung angestrebt.

Die hohe Variabilität der Dicke der auszuformenden Platten äußert sich darin, daß die Spaltbreite der Breitschlitzdüse in einem großen Bereich vom 1,2 bis zum 50fachen, vorzugsweise 1,5- bis 50fachen, insbesondere 1,5 bis 20fachen, der Kalanderspaltbreite eingestellt werden kann.

Die geformte Photopolymerplatte weist, wenn sie den Kalanderspalt verläßt, eine Schichtdicke von 0,1 bis 20 mm auf, bevorzugt 0,2 bis 10 mm.

Mindestens eine der Kalanderwalzen führt eine mitlaufende Folie mit, so daß sich mit der an dem Kalanderspalt austretenden Photopolymerplatte ein Mehrschichtenelement bildet. Als Folien werden insbesondere biaxial gestreckte, aber auch nicht kristalline Polyesterfolien verwendet. Metallfolien sind ebenso geeignet. Vorzugsweise sind die Folien vorbeschichtet, z. B. mit einem Haftvermittler. Die Polyesterfolien können z. B. mit einer Haftschicht, wie sie in der DE-A 37 40 432 beschrieben ist, beschichtet sein. Eine der Folien wirkt dann als Basisschicht, eine als Deckschicht.

Ebenso ist es möglich, anstelle einer Polyesterfolie ein mehrschichtiges Deckelement in den Kalanderspalt einzuführen, das aus einer Polyesterdeckschicht, einer Polyamidschicht und gegebenenfalls einer weiteren photopolymerisierbaren Schicht bzw. einer Schicht, die erst durch den Kontakt mit einer extrudierten photopolymeren Schicht photopolymerisierbar wird. Solche Deckelemente werden in der EP-A 0 084 851 beschrieben.

Ebenso möglich ist, wenn das photopolymerisierbare Material zwischen zwei von Kalanderwalzen mitgeführten Polyesterfolien extrudiert, anschließend eine Folie entfernt und dafür ein mehrschichtiges Deckelement aufgepreßt wird.

Die im Kalanderspalt ausgeformte Photopolymerschicht bzw. das durch Mitlaufen von Folie in den Kalanderspalt hergestellte Mehrschichtenelement verläßt den Kalanderspalt vorzugsweise im 90°-Winkel zu der Verbindungslinie zwischen den Kalanderwalzenachsen.

Das Element bzw. die Schicht wird anschließend weitertransportiert und dabei mit Luft gekühlt. Die Kühlung kann sowohl einseitig als auch von beiden Seiten erfolgen. Vorteilhaft ist eine beidseitige Kühlung, d.h. von oben und unten. Der Weitertransport erfolgt durch ein über zwei Umlenkwalzen geführtes Band, das gegebenenfalls perforiert ist. Vorzugsweise handelt es sich um ein nicht perforiertes Band aus Kunststoff oder Stahl.

Nach der Kühlung und dem Abtransport durch das Band wird die Photopolymerschicht bzw. das Mehrschichtenelement entweder aufgewickelt oder weitertransportiert. Der Weitertransport erfolgt mit einem perforierten Abzugsband, insbesondere aus Stahl, das ebenso über zwei Umlenkwalzen geführt wird. Unter dem perforierten Abzugsband befindet sich ein Vakuumkasten, mit dessen Hilfe die untere Folie auf das Band gezogen wird. Damit kann vorzugsweise eine Zugkraft auf das den Walzenspalt verlassende flächenförmige Gebilde ausgeübt werden.

Die Kombination eines perforierten Abzugsbandes mit einem nicht perforierten bewirkt, daß Deck- und Basisfolie mit der Photopolymerschicht ein Mehrschichtenelement homogen und ohne Blasenbildung sowie unter der Gewährleistung des absoluten Planliegens ausbilden.

Vorzugsweise wird im Bereich, in dem mit einem perforierten Abzugsband weitertransportiert wird oder danach, eine Rückseitenbelichtung vorgenommen, um eine Vernetzung bzw. Teilvernetzung der Schicht zu gewährleisten, so daß zumindest der Sockelbereich in der Photopolymerplatte vernetzt ist. Eine solche Rückseitenbelichtung erleichtert das daran anschließende Formatieren der Photopolymerplatten, das durch Längs- und Querschneiden geschieht. Vorzugsweise wird das Längsschneiden vor der Rückseitenbelichtung vorgenommen, während das Querschneiden danach erfolgt.

Zum Formatieren eignen sich die üblichen Verfahren, wie Laserstrahl-, Wasserstrahl-, Rasierklingen- und rollender Scherenschnitt etc.

Die Dickenkonstanz der erfindungsgemäß hergestellten Photopolymerplatten wird nach Abkühlung des Mehrschichtenelements und nachdem die obere Deckfolie bzw. das mehrschichtige Deckelement entfernt worden ist, gemessen. Die Standardabweichung der über die gesamte Breite der Schicht gemessenen Werte weist im allgemeinen Werte von < ± 0,007 mm, insbesondere von < ± 0,006 mm, auf.

Das erfindungsgemäße Verfahren ermöglicht die Herstellung von Photopolymerplatten mit höherer Dickenkonstanz, in Produktfließrichtung gesehen, und einer Verringerung von Inhomogenitäten gegenüber herkömmlichen Verfahren. Außerdem ermöglicht das Verfahren die Herstellung von Platten eines großen Dickenbereiches, ohne kostenintensiven Umbau der Anlage.

Die vorteilhafte Planlage und Dickenkonstanz im Verbundsystem wird durch das erfindungsgemäße Verfahren ebenso positiv beeinflußt. Hervorzuheben ist die Ausführungsform, in der die Kühlung der Photopolymerschicht unmittelbar nach Verlassen des Kalanderspaltes während des Weitertransports mit einem nicht perforierten Abzugsband erfolgt. Die Bildauftrag erfolgt im allgemeinen nach dem Entfernen der Deckfolie mit aktinischem Licht, wobei die Bildbereiche vernetzen. Die nicht belichteten Bereiche und seine evtl. auf der (den) Polymerschicht(en) noch vorhandene Zwischenschicht(en), z. B. aus Polyamid (vgl. EP-A 0 084 851) werden mit einem üblichen Entwickler entfernt. Eventuell kann daran noch eine Nachhärtung der Schicht mittels Strahlung und/oder Wärme erfolgen.

Die folgenden Beispiele beschreiben die besondere Anwendung des erfindungsgemäßen Verfahrens. In den Beispielen stehen Vt für Volumenteile und Gt für Gewichtsteile, wobei sich Vt zu Gt wie 1:1 verhalten.

Die Prozentangaben beziehen sich, sofern nichts anderes angegeben ist, auf Gewichtsprozente.

### Beispiel 1

Es wird ein Zweischneckenextruder mit einem Schneckendurchmesser von D = 90 mm und einer Schneckenlänge von 28 D eingesetzt, wobei die Schnecken in gleichem Drehsinn rotieren. Der Extruder besteht aus vier Bereichen mit insgesamt sechs Zonen: einer Einzugszone für die Dosierung von Feststoffen mit einer Länge von 3 D und fünf separat temperierbaren Zonen mit einer Länge von je 5 D. Die Schnecken sind aus verschiedenen Schneckenelementen zusammengesetzt, u.a. aus selbstreinigenden Förderelementen, Knet- und Zahnblöcken.

In die 1. Zone (Einzugszone) werden 61,2 kg/h eines Styrol/Isopren/Styrol-Dreiblockpolymeren (15 Gew.-% Styrolgehalt) eindosiert. In die 3. Zone (in Prozeßrichtung gesehen) werden 13,8 kg/h einer auf 60 °C vorgewärmten flüssigen Mischung, bestehend aus
21,6 Gt Hexandioldiacrylat,
10,8 Gt Hexandioldimethacrylat,
2,5 Gt 2,6-Di-tert.-butylkresol
10,5 Gt Benzildimethylketal,
5,4 Gt Mikrowachs (Schutzbereich ca. 60 °C)
32,4 Gt eines paraffinischen Öls (kinematische Viskosität bei 20 °C, 250 mm²/s)
16,2 Gt eines α-methylstyrol-Vinyltoluol-Copolymerisats und
0,0005 Gt Solvent Black 3
zudosiert. In der 5. Zone befindet sich eine Entgasungsöffnung, an die in Vakuum von 450 mbar angelegt wird.

An das Extruderende ist eine gerade-verzahnte Zahnradschmelzepumpe angeflanscht. Die daran anschließende Breitschlitzdüse weist eine Austrittsöffnung von 20 x 450 mm auf. Bei einer Schneckendrehzahl von 30 min⁻¹ werden die Zonen des Extruders derart temperiert, daß die Schmelzetemperatur nach der Zahnradpumpe 147 °C beträgt.

Die aus der Düse austretende Schmelze wird in den Spalt eines Zweiwalzenkalanders mit Walzen von 1000 mm Ballenlänge und 400 mm Durchmesser zwischen zwei 0,125 mm dicken Polyesterfolien so geführt, daß sich kein Rollwulst ausbildet. Beide Kalanderwalzen drehen sich gleich schnell.

Das den Walzenspalt verlassende Mehrschichtenelement wird in 90° zu der Achse der beiden Walzen zuerst mit einem nicht perforierten Abzugsband weitertransportiert und gleichzeitig von oben und unten gekühlt. Anschließend erfolgt der Weitertransport mit einem perforierten Stahlabzugsband einer Geschwindigkeit von 1 m/min mit einem unter dem perforierten Stahlband liegenden Vakuumkasten. Die Geschwindigkeiten des Stahlbandes und der Walzen des Kalanders sind synchronisiert.

Nach Abkühlung des Mehrschichtenelements wird die obere Polyesterfolie abgezogen und die Dicke des Mehrschichtenelements gemessen. Der Mittelwert der Dicke beträgt 3,113 mm. Die Standardabweichung der 38 Meßwerte für eine Laufzeit von 39 Minuten, wobei jede Minute eine Messung erfolgte, in Prozeßrichtung betrug ± 0,005 mm.

Das Beispiel wird wiederholt, wobei man den Kalanderspalt so einstellt, ohne Änderung der Breitschlitzdüse, daß sich eine Produktdicke von 1,1 und bei einem weiteren Beispiel 6,0 mm ergibt.

Die Abzugsgeschwindigkeit beträgt bei der 1,1 mm dicken Platte ca. 3 m/min, bei der 6,0 mm dicken Platte ca. 0,5 m/min.

### Beispiel 2

Es wird wie in Beispiel 1 beschrieben gearbeitet. Diesmal werden jedoch 183,6 kg/h Dreiblockcopolymer in die Einzugszone und 41,4 kg/h der vorgewärmten flüssigen Mischung in die 3. Zone eindosiert. Die Schneckendrehzahl beträgt 57 min⁻¹, die Schmelzetemperatur nach der Zahnradpumpe 167 °C. Das Mehrschichtenelement verläßt mit einer Geschwindigkeit von 3 m/min den Kalanderspalt. Nach Abkühlung des Mehrschichtenelements und Abzug der oberen Polyesterfolie beträgt der Mittelwert der Dicke 2,903 mm, die Standardabweichung der 32 Meßwerte (Meßwert/min) in Prozeßrichtung beträgt ± 0,006 mm.

In diesem Beispiel wird außerdem während des Weitertransports mit dem perforierten Abzugsband eine vollflächige Rückseitenbelichtung (Teilvernetzung) mit einer 40 W UV-Fluoreszenslampe vorgenommen.

Zur Prüfung der Homogenität werden dem Mehrschichtenelement an verschiedenen Stellen Proben der Photopolymerschicht entnommen, in Toluol aufgelöst und durch Messung der Extinktion der Extinktionskoeffizient in 1/g.cm bei einer Wellenlänge von 600 nm bestimmt. Die Standardabweichung beträgt 0,8 % des Mittelwertes des Extinktionskoeffizienten.

## Patentansprüche

1. Kontinuierlich arbeitendes Verfahren zur Herstellung von Photopolymerplatten, bei dem ein photopolymerisierbares Gemisch, enthaltend wenigstens ein thermoplastisch verarbeitbares, elastomeres Polymeres, wenigstens eine einfach oder mehrfach ethylenisch ungesättigte Verbindung, die radikalisch polymerisierbar ist und einen Siedepunkt bei Normaldruck oberhalb von 100 °C hat, sowie wenigstens eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und anschließend über eine Breitschlitzdüse einem Zweiwalzenkalander zugeführt wird, dadurch gekennzeichnet, daß die Schmelze nach dem Schneckenextruder über eine Schmelzedosierpumpe in die Breitschlitzdüse weitertransportiert und dem Zweiwalzenkalander mit einer solchen Geschwindigkeit zugeführt wird, daß sich im Walzenspalt kein rotierender Wulst ausbildet.

2. Verfahren nach Anspruch 1, dadurch gekennzeichnet, daß der Schneckenextruder ein selbstreinigender Zweischneckenextruder ist.

3. Verfahren nach einem der Ansprüche 1 oder 2, dadurch gekennzeichnet, daß der Schneckenextruder neben den selbstreinigenden Förderelementen noch Knet- und Zahnblöcke enthält.

4. Verfahren nach einem der Ansprüche 1 bis 3, dadurch gekennzeichnet, daß die festen Bestandteile in den vorzugsweise nicht beheizten 1. Bereich eindosiert werden und die flüssigen Bestandteile, gegebenenfalls mit mit dem Rest noch nicht eindosierter fester Bestandteile, in einer oder mehreren Eintragsöffnung(en) der folgenden Bereiche zudosiert werden, wobei diese Bereiche geheizt sind, so daß das Gemisch aufgeschmolzen wird.

5. Verfahren nach einem der Ansprüche 1 bis 4, dadurch gekennzeichnet, daß in den 1. Bereich eine Vormischung der Bestandteile des photopolymerisierbaren Gemisches eindosiert wird.

6. Verfahren nach Anspruch 5, dadurch gekennzeichnet, daß diese Vormischung in einem Pflugschar-, Bandschnecken-, Paddel-, Trommel- oder Freifallmischer vorgenommen wird.

7. Verfahren nach einem der Ansprüche 5 oder 6, dadurch gekennzeichnet, daß der Mischung ein in den flüssigen Bestandteilen nicht lösliches Pulver einer mittleren Korngröße von 0,005 bis 50 »m beigemischt und das Polymere in Granulatform eingesetzt wird.

8. Verfahren nach einem der Ansprüche 1 bis 7, dadurch gekennzeichnet, daß die mittlere Temperatur 100 bis 220 °C, insbesondere 130 bis 170 °C, beträgt.

9. Verfahren nach einem der Ansprüche 1 bis 8, dadurch gekennzeichnet, daß der Entgasungsbereich eine Temperatur von 60 bis 140 °C aufweist.

10. Verfahren nach einem der Ansprüche 1 bis 9, dadurch gekennzeichnet, daß die Schneckenlänge des Extruders insgesamt das 5- bis 50fache, vorzugsweise das 10- bis 40fache des Schneckendurchmessers beträgt.

11. Verfahren nach einem der Ansprüche 1 bis 10, dadurch gekennzeichnet, daß es sich bei der Schmelzedosierpumpe um eine gerade-verzahnte Zahnradschmelzepumpe handelt.

12. Verfahren nach einem der Ansprüche 1 bis 11, dadurch gekennzeichnet, daß die Spaltbreite der Breitschlitzdüse das 1,2- bis 50fache, vorzugsweise das 1,5- bis 50fache, der Kalanderspaltbreite beträgt.

13. Verfahren nach einem der Ansprüche 1 bis 12, dadurch gekennzeichnet, daß die Umlaufgeschwindigkeit der Walzen des Zweiwalzenkalanders und die Geschwindigkeit der Schmelzepumpe in der Weise geregelt ist, daß sich kein rotierender Wulst ausbildet.

14. Verfahren nach einem der Ansprüche 1 bis 13, dadurch gekennzeichnet, daß die Walzen des Kalanders jeweils eine mitlaufende Folie aufweisen.

15. Verfahren nach einem der Ansprüche 1 bis 14, dadurch gekennzeichnet, daß die den Kalanderspalt verlassende Schicht in einem Winkel von 90° zu der Verbindungslinie zwischen den Kalanderwalzenachsen weitertransportiert wird.

16. Verfahren nach Anspruch 15, dadurch gekennzeichnet, daß der Weitertransport mit einem Abzugsband, vorzugsweise einem nicht perforierten Abzugsband, erfolgt.

17. Verfahren nach Anspruch 16, dadurch gekennzeichnet, daß gleichzeitig von oben und unten mit Luft gekühlt wird.

18. Verfahren nach einem der Ansprüche 16 bis 17, dadurch gekennzeichnet, daß der weitere Transport mit einem perforierten Abzugsband erfolgt.

19. Verfahren nach Anspruch 18, dadurch gekennzeichnet, daß mit einem Vakuum die Fixierung auf dem Band erfolgt.

20. Verfahren nach einem der Ansprüche 15 bis 19, dadurch gekennzeichnet, daß während des Weitertransports eine vollflächige von einer Seite erfolgende Teilbelichtung (Rückseitenbelichtung) erfolgt.

## Claims

1. Continuously working process for the production of photopolymer plates, wherein a photopolymerizable mixture containing at least one thermoplastic elastomeric polymer, at least one ethylenically mono- or poly-unsaturated compound which can be polymerized by free radicals and has a boiling point of more than 100 °C at atmospheric pressure, and at least one compound or a compound combination capable of initiating polymerization of said unsaturated compounds is introduced into a screw extruder, melted and degassed and then fed by a sheet die into a two roll calender, characterized in that after the screw extruder the melt is transported into the sheet die by a melt metering pump and conveyed to the two roll calender at such a rate that no rotating bead is formed in the roll gap.

2. A process according to claim 1, characterized in that,
the screw extruder is a self-cleaning twin-screw extruder.

3. A process according to one of claims 1 or 2, characterized in that,
the screw extruder comprises besides the self-cleaning conveying means kneading and toothed blocks.

4. A process according to one of claims 1 or 3, characterized in that,
the solid components are preferrably fed into the unheated first section and the liquid components, optionally with the rest of not yet introduced solid components, are fed into one or more feed openings of the following sections, whereby these sections are heated so that the mixture is melted.

5. A process according to one of claims 1 to 4, characterized in that,
a pre-mixture of the components of the photopolymerizable mixture is fed into the first section.

6. A process according to claim 5, characterized in that,
the pre-mixing is effected in a ploughshare, ribbon, paddle, drum or free-falling mixer.

7. A process according to one of claims 5 or 6, characterized in that,
a powder which is insoluble in the liquid components of the mixture and has an average particle size of about 0.005 to 50 »m is added to the mixture and wherein the polymer is used in the form of granules.

8. A process according to one of claims 1 to 7, characterized in that,
the average temperature is 100 to 220 °C, especially 130 to 170 °C.

9. A process according to one of claims 1 to 8, characterized in that,
the degassing section has a temperature of 60 to 140 °C.

10. A process according to one of claims 1 to 9, characterized in that,
the overall screw length of the extruder is 5 to 50 times, preferrably 10 to 40 times, the screw diameter.

11. A process according to one of claims 1 to 10, characterized in that,
the melt metering pump is a spur-toothed gear pump.

12. A process according to one of claims 1 to 11, characterized in that,
the gap width of the sheet die is 1.2 to 50 times, especially 1.5 to 50 times, the calender gap width.

13. A process according to one of claims 1 to 12 characterized in that,
the rotating speed of the rolls of the two-roll calender and the speed of the metering pump are controlled in such a manner that no rotating bead is formed.

14. A process according to one of claims 1 to 13, characterized in that,
each roll of the calender carries a film.

15. A process according to one of claims 1 to 14, characterized in that,
the sheet leaving the calender gap is transported at an angle of 90° relative to the connecting line between the axes of the calender rolls.

16. A process according to claim 15, characterized in that,
the sheet is transported by means of a take-off belt, especially by means of a non-perforated take-off belt.

17. A process according to claims 16, characterized in that,
top and bottom are simultaneously cooled with air.

18. A process according to one of claims 16 or 17, characterized in that,
the sheet is further transported by means of a second perforated take-off belt.

19. A process according to claim 18, characterized in that,
the sheet is fixed on the belt by means of a vacuum.

20. A process according to one of claims 15 to 19, characterized in that,
during the transport the sheet is partially exposed overall from one side (back exposure).

## Revendications

1. Procédé de fabrication en continu de plaques de photopolymère dans lequel un mélange photopolymérisable contenant au moins un polymère élastomère se prêtant à une transformation thermoplastique, au moins un dérivé présentant une ou plusieurs insaturations éthyléniques, qui est polymérisable par voie radicalaire et présentant un point d'ébullition supérieur à 100°C à la pression normale, ainsi que au moins un dérivé ou une combinaison de dérivés qui permet l'induction d'une polymérisation des dérivés insaturés sous l'action d'une lumière actinique, est introduit dans une extrudeuse à vis, y sont fondus et dégazés, et amenés ensuite, après passage par un ajutage à large fente, dans une calandre à deux cylindres, caractérisé en ce que, après son passage dans l'extrudeuse à vis, la masse fondue est encore acheminée, par l'intermédiaire d'une pompe doseuse de masse fondue, dans l'ajutage à large fente, puis est amenée à la calandre à deux cylindres à une vitesse telle que, dans l'espace existant entre les cylindres de la calandre, il ne se forme pas de bourrelet tournant.

2. Procédé selon la revendication 1, caractérisé en ce que l'extrudeuse à vis est une extrudeuse à deux vis auto-nettoyante.

3. Procédé selon l'une quelconque des revendications 1 ou 2, caractérisé en ce que, outre les éléments d'acheminement auto-nettoyants, l'extrudeuse à vis comporte encore des blocs de pétrissage et des blocs dentés.

4. Procédé selon l'une quelconque des revendications 1 à 3, caractérisé en ce que les constituants solides sont introduits dans la première zone de préférence non chauffée, et les constituants liquides, éventuellement en même temps que le reste des constituants solides non encore introduits, sont introduits dans un ou plusieurs orifices d'entrées des zones suivantes, ces zones étant chauffées de façon à ce que le mélange soit fondu.

5. Procédé selon l'une quelconque des revendication 1 à 4, caractérisé en ce que l'on introduit dans la première zone des constituants du mélange photopolymérisable préalablement mélangés.

6. Procédé selon la revendication 5, caractérisé en ce que ce mélange préliminaire est effectué dans un malaxeur à ailette, un malaxeur à bandes, un malaxeur à pales, un malaxeur à tambour ou un malaxeur à chute libre.

7. Procédé selon l'une quelconque des revendications 5 ou 6, caractérisé en ce qu'une poudre, non soluble dans les constituants liquides, présentant une granulométrie moyenne de 0,005 à 50 »m est ajoutée au mélange et le polymère est utilisé sous forme de granulés.

8. Procédé selon l'une quelconque des revendications 5 ou 6, caractérisé en ce que la température moyenne est de 100 à 220°C, en particulier de 130 à 170°C.

9. Procédé selon l'une quelconque des revendications 1 à 8, caractérisé en ce que la zone de dégazage est à une température de 60°C à 140°C.

10. Procédé selon l'une quelconque des revendications 1 à 9, caractérisé en ce que la longueur totale de vis de l'extrudeuse est de 5 à 50 fois, de préférence de 10 à 40 fois, le diamètre de la vis.

11. Procédé selon l'une quelconque des revendications 1 à 10, caractérisé en ce que la pompe doseuse de matière fondue est une pompe de matière fondue à pignon à denture droite.

12. Procédé selon l'une quelconque des revendications 1 à 11, caractérisé en ce que la largeur entre les lèves de l'ajutage à large fente atteint de 1,2 à 50 fois, de préférence de 1,5 à 50 fois, la largeur de l'espace entre les cylindres de la calandre.

13. Procédé selon l'une quelconque des revendications 1 à 12, caractérisé en ce que la vitesse de rotation des cylindres de la calandre à double cylindre et la vitesse de la pompe doseuse sont réglées de façon à ce qu'il ne se forme pas de bourrelets tournants.

14. Procédé selon l'une quelconque des revendications 1 à 13, caractérisé en ce que les cylindres de la calandre entraînent simultanément une feuille.

15. Procédé selon l'une quelconque des revendications 1 à 14, caractérisé en ce que la couche quittant la fente de la calandre est transportée suivant un angle de 90 degrés avec la ligne reliant les axes des cylindres de la calandre.

16. Procédé selon la revendication 15, caractérisé en ce que la poursuite du transport se fait à l'aide d'une bande d'entraînement, de préférence une bande d'entraînement non perforée.

17. Procédé selon la revendication 16, caractérisé en ce que l'on effectue un refroidissement à l'air simultanément par-dessus et par-dessous.

18. Procédé selon l'une quelconque des revendications 16 à 17, caractérisé en ce que le transport est poursuivi à l'aide d'une bande d'entraînement perforée.

19. Procédé selon la revendication 18, caractérisé en ce que la fixation sur la bande se fait par application de vide.

20. Procédé selon l'une quelconque des revendications 15 à 19, caractérisé en ce que, pendant la poursuite du transport, on effectue une exposition partielle de la totalité de la surface d'une face (exposition de la face postérieure).
